Europäisches Patentamt

European Patent Office

Office européen des brevets

(11) Publication number: **0 072 153**
A2

## (12) EUROPEAN PATENT APPLICATION

(21) Application number: **82304005.0**

(22) Date of filing: **29.07.82**

(51) Int. Cl.³: **H 03 K 3/53**
// G01S7/28

(30) Priority: **08.08.81 GB 8124318**

(43) Date of publication of application: **16.02.83**
Bulletin 83/7

(84) Designated Contracting States: **AT BE CH DE FR IT LI LU NL SE**

(71) Applicant: **THE MARCONI COMPANY LIMITED, The Grove Warren Lane, Stanmore Middlesex HA7 4LY (GB)**

(72) Inventor: **Richardson, Robert, 42, King Edwards Road South Woodham Ferrers, Chelmsford Essex (GB)**

(74) Representative: **Hoste, Colin Francis et al, Marconi House New Street, Chelmsford Essex CM1 1PL (GB)**

(54) **A generator of short duration high power pulses.**

(57) A pulse generator is operative to produce a series of very short, high energy pulses by allowing a reactive network to charge periodically from a d.c. power supply over a relatively long interval, and then rapidly discharging the accumulated energy into a load. The generator is intended for use in a radar transmitter. The peak level to which the reactive network charges is dependent on the charging period, and the invention enables the peak level to be controlled by charging the network via an inductor, and allowing the inductor current to build up to a substantial level before charging of the network commences. When the inductor current reaches a required level, it is diverted to the reactive network. In this way a series of high power pulses having uniform peak levels is generated in a very convenient manner.

TITLE MODIFIED
see front page

A pulse generator

This invention relates to pulse circuits which are capable of generating high power pulses of short duration. A circuit of this kind can be used, for example, to provide the operating power for a high power oscillator, such as a magnetron, which forms part of a radar transmitter. Such a pulse circuit is sometimes termed a radar pulse modulator. A radar transmitter commonly transmits pulses having a very low mark-to-space ratio, that is to say, transmitted short pulses are spaced apart in time by relatively long intervals during which echoes of the pulses are returned by intercepted radar targets to a radar receiver.

It is customary to use a pulse forming network to generate pulses of the required characteristics. In a pulse forming network, an array of capacitors and one or more inductors are charged to a required voltage level, and when fully charged the network is discharged, typically into a pulse transformer which raises the voltage to a level (typically 30 kV) at which it can be used to drive a magnetron oscillator.

Variations in the level to which the pulse forming network is charged can lead to significant fluctuations in the pulse characteristics, particularly its peak voltage level. These variations are likely to be small but not insignificant in those cases in which the pulse generator is operative to produce a sequence of pulses which are regularly spaced apart in time, but changes in the pulse repetition rate can lead to unpredictable or unacceptably large fluctuations in pulse amplitude. The present invention seeks to provide an improved pulse generator in which this difficulty is reduced in a particularly satisfactory manner.

According to this invention, a pulse generator includes a pulse forming network having capacitance and inductance; means for resonantly charging the pulse forming network from a supply voltage via an inductor, and for subsequently discharging the pulse forming network to produce an output pulse; and means for establishing current flow through said inductor prior to the instant at which charging of the pulse forming network commences, whereby the peak voltage value to which the pulse forming network is charged is dependent on the magnitude of said current flow at said instant.

The current flowing through said inductor increases at a predictable rate from zero when the voltage is applied across it. Thus the value of the current flowing through said inductor at the instant at which charging of the pulse forming network is allowed to commence is itself a function of the period for which the current has been flowing. By accurately adjusting this period of time the output voltage value of the pulse forming network can be controlled and hence one can maintain uniformity in the sequence of pulses which is generated. The invention enables compensation to be provided for variation in the voltage level of the power supply from which the pulse generator takes its energy. The power drawn by the pulse generator from the power supply is not steady, but fluctuates in a periodic manner and inevitably the supply voltage will decay somewhat whilst power is being drawn from the power supply, and the supply voltage will then recover towards its nominal value. If the pulse sequence generated by the pulse generator is perfectly regular, then the supply voltage will have recovered to exactly the same level on each occasion that power is drawn from it. However, if the pulse generator is operative to produce an irregular sequence of pulses, the recovery periods of the power supply will not be constant, and this can lead to variations and irregularities in the voltage and power levels of the pulses which are generated.

The invention is further described by way of example with reference to the accompanying drawings, in which

Figure 1 shows a pulse generator in a simplified diagrammatic form, and

Figure 2 is an explanatory diagram.

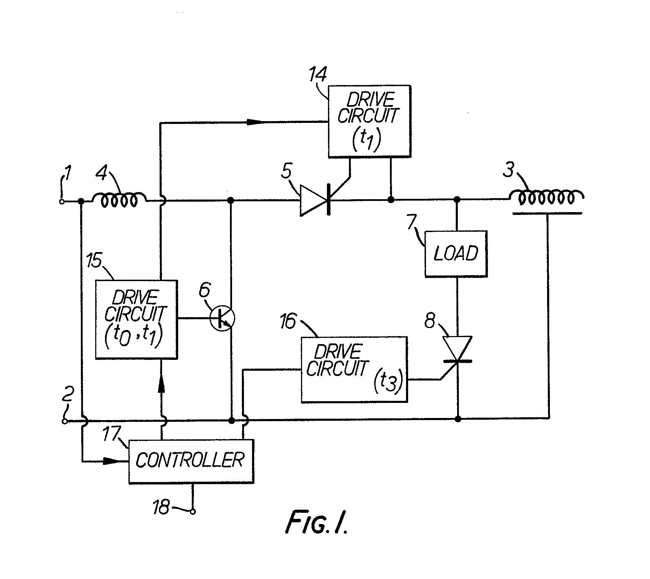

Referring to Figure 1, a.d.c power supply is connected to terminals 1 and 2 of a pulse generator. A pulse forming network 3 consisting of an array of inductance and capacitance in known manner is connected to the terminal 1 via a charging inductor 4 and a switch which takes the form of a triggerable thyristor 5. A switchable transistor 6 is connected between terminal 2 and the inductor 4. In operation, the pulse forming network 3 is charged from the power supply connected to terminals 1 and 2, and it is then subsequently discharged into a load 7 when a further switchable thyristor 8 is triggered.

A pulse generator of this kind is particularly suitable for driving a magnetron oscillator which forms part of a radar transmitter. A magnetron oscillator is a relatively efficient source of microwave oscillations, but it requires high voltage pulse (of the order of 30 kV) to operate it - the magnetron oscillates whilst a voltage applied to it exceeds a threshold value. The pulse generator produces pulses at a much lower voltage, typically of the order of 600 volts, and these pulses are fed via a transformer to the magnetron. In Figure 1, the voltage transformer and the magnetron are represented simply as the load 7.

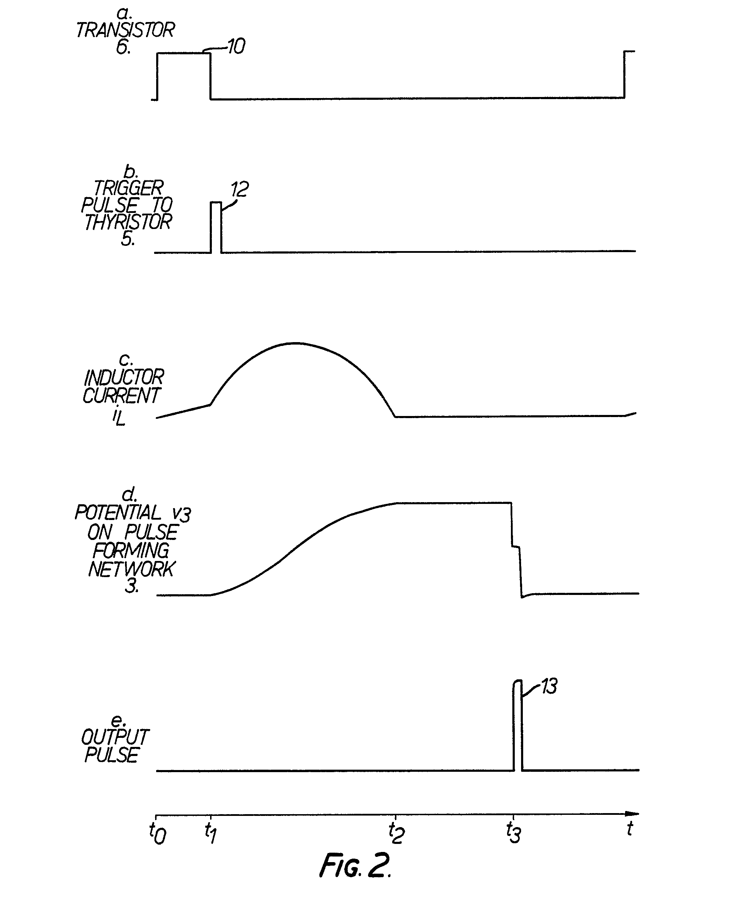

The operation of the pulse generator shown in Figure 1 is as follows. It is assumed that initially the pulse forming network 3 is discharged, and that both thyristors 5 and 8 are in their non-conductive states. The sequence of events is illustrated diagrammatically with reference to Figure 2. At time $t_0$ a pulse 10 (as shown in line $\underline{a}$ of Figure 2) is fed to transistor 6 which renders it conductive and current $i_L$ begins to flow through the inductor 4, and in conventional manner it increases from zero at an approximately linear rate. At time $t_1$, transistor 6 is rendered non-conductive and simultaneously the thyristor 4 is triggered into its conductive state by the application of a trigger pulse 12 (as shown in line $\underline{b}$ of Figure 2). The pulse forming network 3 in combination with the inductor 4 behaves as a resonant circuit, so that the pulse forming network is resonantly charged. The technique of resonantly charging a pulse forming network is in itself well known. As the thyristor 5 becomes non-conductive when the current flow through it passes through zero, it behaves as a rectifying device - that is to say, the current charging of the pulse forming network 3 automatically ceases when the current $i_L$ returns to zero at time $t_2$. The voltage $v_3$ on the pulse forming network 3 rises during the interval $t_1$ to $t_2$ to reach the peak value which is related to the supply voltage present at terminals 1 and 2 and the current initially flowing through inductor 4 at the instant $t_1$ that thyristor 5

is rendered conductive. The current $i_L$ and the voltage $v_3$ are shown in lines $\underline{c}$ and $\underline{d}$ of Figure 2 respectively. In the absence of any current flow through inductor 4 when thyristor 5 is triggered, the voltage peak to which the pulse forming network is charged is twice the supply voltage under conditions of resonant charge transfer, assuming no losses.

It will thus be apparent that by adjusting the initial time period $t_o$ to $t_1$ during which the current $i_L$ increases, the final charging voltage of the pulse forming network 3 can be adjusted. The time interval $t_1$ to $t_2$ is the time taken for the current $i_L$ to return resonantly to zero, and it is determined not only by the value of the inductor 4 and the inductance and capacity of the pulse forming network 3, but also by the value of current $i_L$ at the instant $t_1$. At the time $t_2$, the thyristor 5 becomes reverse biassed, as previously mentioned, and its recovery period commences. When a short period has elapsed to ensure that its recovery is complete, the thyristor 8 is rendered conductive to enable the pulse forming network 3 is discharge through the load 7. The pulse forming network 3 discharges very rapidly, and as it does so an output pulse 13 is generated. This output pulse 13 is shown in line $\underline{e}$ of Figure 2 and it commences at time $t_3$. Typically it has a duration which is very short indeed to the period $t_o$ to $t_2$ during which energy is being transferred from the power supply to the pulse forming network 3. In this way the pulse can possess an extremely high peak power level - that is to say, the peak current flowing through the load 7 can be very large indeed.

It will be apparent that if the transistor 6 fails to operate, i.e. become conductive, the network voltage will be somewhat less than the required value. However, a voltage surge is not developed under these conditions, and the pulse generator can continue operation, although, of course, its output level is not properly regulated.

The three switchable devices 5, 6 and 8 are provided with respective drive circuits 14, 15, 16 under the control of a controller 17. Controller 17 is operative to monitor the voltage level at terminal1 which is provided by the d.c. power supply, since the time $t_o$ is controlled to compensate for vdtage variations. Information as to the required timing $t_3$ of the output pulse 13 is fed via terminal 18 into the controller 17, which causes the drive circuit 15 to trigger the transistor 6 at a time $t_o$ which will enable variations in the voltage at terminal 1 to be taken into account. Subsequently, at time $t_1$, the controller 17 causes drive circuit 15 to render transistor 6 non-conductive, and simultaneously causes drive circuit 14 to trigger thyristor 5. Finally when time $t_3$ arrives the drive circuit 16 triggers thyristor 8 under control of the controller 17 to generate an output pulse.

Claims

1.    A pulse generator including a pulse forming network having capacitance and inductance; means for resonantly charging the pulse forming network from a supply voltage via an inductor, and for subsequently discharging the pulse forming network to produce an output pulse; and means for establishing current flow through said inductor prior to the instant at which charging of the pulse forming network commences, whereby the peak voltage value to which the pulse forming network is charged is dependent on the magnitude of said current flow at said instant.

2.    A pulse generator as claimed in claim 1 and wherein the magnitude of the current flowing through said inductor at said instant is a function of the time during which current has been flowing at said instant.

3.    A pulse generator as claimed in claim 1 or 2 and wherein prior to said instant, the supply voltage is applied across said inductor by the action of a switch connected in series with it, and wherein means are provided for simultaneously rendering said switch non-conductive and rendering conductive a further switch positioned between said inductor and said pulse forming network, so as to direct the established inductor current to charge said pulse forming network.

FIG.I.

0072153

FIG. 2.